(19) Europäisches Patentamt
European Patent Office
Office européen des brevets

(11) **EP 4 692 990 A1**

(12) **EUROPEAN PATENT APPLICATION**
published in accordance with Art. 153(4) EPC

(43) Date of publication:
**11.02.2026 Bulletin 2026/07**

(21) Application number: **24777846.7**

(22) Date of filing: **21.03.2024**

(51) International Patent Classification (IPC):
*G06F 3/01* ^(2006.01)

(52) Cooperative Patent Classification (CPC):
**G06F 3/01; G06F 16/11; G06F 16/16; G06F 16/174**

(86) International application number:
**PCT/CN2024/082836**

(87) International publication number:
**WO 2024/199057 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.03.2023 CN 202310312430**

(71) Applicant: **Vivo Mobile Communication Co., Ltd.**
**Dongguan, Guangdong 523863 (CN)**

(72) Inventors:
• **LV, Zhuoyi**
  **Dongguan, Guangdong 523863 (CN)**
• **LIN, Huhu**
  **Dongguan, Guangdong 523863 (CN)**

(74) Representative: **Shieldmark**
**P.O. Box 90471**
**2509 LL The Hague (NL)**

(54) **HAPTIC DATA ENCODING METHOD, HAPTIC DATA DECODING METHOD, AND RELATED DEVICE**

(57) The present application discloses a method for encoding haptic data, a method for decoding haptic data, and related devices, belonging to the technical field of computers. The method for encoding haptic data in embodiments of the present application includes: obtaining a position of each of a plurality of keyframes of an effect in haptic data, where the plurality of keyframes include a first target keyframe and a second target keyframe, and the second target keyframe is a keyframe located before the first target keyframe; determining encoding position information of the first target keyframe, where the encoding position information of the first target keyframe is determined according to a difference between a position of the first target keyframe and a position of the second target keyframe; and encoding the encoding position information of the first target keyframe to obtain a first encoding result, where an encoding result of the haptic data includes the first encoding result.

```
          ┌──────────┐
          │  Start   │
          └────┬─────┘
               ▼
┌─────────────────────────────────────────────┐
│ Obtain a position of each of a plurality of  │ ─ 101
│ keyframes of an effect in haptic data         │
└────────────────┬────────────────────────────┘
                 ▼
┌─────────────────────────────────────────────┐
│ Determine encoding position information of    │ ─ 102
│ the first target keyframe                     │
└────────────────┬────────────────────────────┘
                 ▼
┌─────────────────────────────────────────────┐
│ Encode the encoding position information of   │ ─ 103
│ the first target keyframe to obtain a first   │
│ encoding result                               │
└────────────────┬────────────────────────────┘
                 ▼
          ┌──────────┐
          │   End    │
          └──────────┘
```

FIG. 3

Description

CROSS-REFERENCE TO RELATED APPLICATIONS

This application claims the priority of Chinese Patent Application No. 202310312430.6 filed in China on March 28, 2023, which is hereby incorporated by reference in its entirety.

TECHNICAL FIELD

This application belongs to the technical field of computers, and specifically relates to a method for encoding haptic data, a method for decoding haptic data, and related devices.

BACKGROUND

As the importance of haptics in consumer peripheral devices increases, haptic encoding becomes increasingly important. For haptic encoding, the moving pictures experts group (Moving Pictures Experts Group, MPEG) defines four types of haptic bands (Haptic Bands): transient bands (Transient bands), curve bands (Curve bands), vectorial wave bands (Vectorial Wave bands), and wavelet wave bands (Wavelet Wave bands). Each band is composed of a series of "effects (Effects)" of a same type as that of the band, and each Effect is defined by a "keyframes (Keyframes)" list. During haptic encoding, position information of a keyframe of each Effect needs to be encoded.

In a related technology, when position information of a keyframe of an Effect is encoded, difference information between a position of the keyframe and an Effect position is encoded, resulting in relatively large data redundancy and relatively low encoding efficiency.

SUMMARY

Embodiments of this application provide a method for encoding haptic data, a method for decoding haptic data, and related devices, so as to solve the problem of relatively low encoding efficiency.

According to a first aspect, a method for encoding haptic data is provided. The method includes:

obtaining a position of each of a plurality of keyframes of an effect in haptic data, where the plurality of keyframes include a first target keyframe and a second target keyframe, and the second target keyframe is a keyframe located before the first target keyframe;

determining encoding position information of the first target keyframe, where the encoding position information of the first target keyframe is determined according to a difference between a position of the first target keyframe and a position of the second target keyframe; and

encoding the encoding position information of the first target keyframe to obtain a first encoding result, where an encoding result of the haptic data includes the first encoding result.

According to a second aspect, a method for decoding haptic data is provided. The method includes:

decoding a first encoding result in an encoding result of the haptic data to obtain encoding position information of a first target keyframe, where the encoding position information corresponding to the first target keyframe is determined according to a difference between a position of the first target keyframe and a position of a second target keyframe, the first target keyframe and the second target keyframe are keyframes in a plurality of keyframes of an effect in the haptic data, and the second target keyframe is a keyframe located before the first target keyframe; and

determining the position of the first target keyframe based on the encoding position information of the first target keyframe.

According to a third aspect, an apparatus for encoding haptic data is provided. The apparatus includes:

an obtaining module, configured to obtain a position of each of a plurality of keyframes of an effect in haptic data, where the plurality of keyframes include a first target keyframe and a second target keyframe, and the second target keyframe is a keyframe located before the first target keyframe;

a first determining module, configured to determine encoding position information of the first target keyframe, where the encoding position information of the first target keyframe is determined according to a difference between a position of the first target keyframe and a position of the second target keyframe; and

a first encoding module, configured to encode the encoding position information of the first target keyframe to obtain a first encoding result,
where an encoding result of the haptic data includes the first encoding result.

According to a fourth aspect, an apparatus for decoding haptic data is provided. The apparatus includes:

a decoding module, configured to decode a first encoding result in an encoding result of the haptic data to obtain encoding position information of a first target keyframe, where the encoding position information corresponding to the first target keyframe is determined according to a difference between a position of the first target keyframe and a position of a second target keyframe, the first target keyframe and the second target keyframe are keyframes in a plurality of keyframes of an effect in the haptic data, and the second target keyframe is a keyframe located before the first target keyframe; and
a first determining module, configured to determine the position of the first target keyframe based on the encoding position information of the first target keyframe.

According to a fifth aspect, a terminal is provided. The terminal includes a processor and a memory. The memory stores a program or instruction executable on the processor. The program or instruction, when executed by the processor, implements the steps of the method according to the first aspect, or implements the steps of the method according to the second aspect.

According to a sixth aspect, a terminal is provided. The terminal includes a processor and a communication interface, where the processor is configured to: obtain a position of each of a plurality of keyframes of an effect in haptic data, where the plurality of keyframes include a first target keyframe and a second target keyframe, and the second target keyframe is a keyframe located before the first target keyframe; determine encoding position information of the first target keyframe, where the encoding position information of the first target keyframe is determined according to a difference between a position of the first target keyframe and a position of the second target keyframe; and encode the encoding position information of the first target keyframe to obtain a first encoding result, where an encoding result of the haptic data includes the first encoding result.

According to a seventh aspect, a terminal is provided. The terminal includes a processor and a communication interface, where the processor is configured to: decode a first encoding result in an encoding result of haptic data to obtain encoding position information of a first target keyframe, where the encoding position information corresponding to the first target keyframe is determined according to a difference between a position of the first target keyframe and a position of a second target keyframe, the first target keyframe and the second target keyframe are keyframes in a plurality of keyframes of an effect in the haptic data, and the second target keyframe is a keyframe located before the first target keyframe; and determine the position of the first target keyframe based on the encoding position information of the first target keyframe.

According to an eighth aspect, a readable storage medium is provided. The readable storage medium stores a program or an instruction. The program or instruction, when executed by a processor, implements the steps of the method according to the first aspect, or implements the steps of the method according to the second aspect.

According to a ninth aspect, an encoding and decoding system is provided. The encoding and decoding system includes: an encoding-side device and a decoding-side device. The encoding-side device can be used for implementing the steps of the method according to the first aspect, and the decoding-side device can be used for implementing the steps of the method according to the second aspect.

According to a tenth aspect, a chip is provided. The chip includes a processor and a communication interface. The communication interface is coupled to the processor. The processor is configured to execute a program or an instruction to implement the method according to the first aspect or implement the method according to the second aspect.

According to an eleventh aspect, a computer program/program product is provided. The computer program/-program product is stored in a storage medium. The program/program product is executed by at least one processor to implement the steps of the method according to the first aspect or implement the steps of the method according to the second aspect.

In the embodiments of this application, the position of each of the plurality of keyframes of the effect in the haptic data is obtained, where the plurality of keyframes include the first target keyframe and the second target keyframe, and the second target keyframe is the keyframe located before the first target keyframe; the encoding position information of the first target keyframe is determined, where the encoding position information of the first target keyframe is determined according to a difference between the position of the first target keyframe and the position of the second target keyframe; and the encoding position information of the first target keyframe is encoded to obtain the first encoding result, where the encoding result of the haptic data includes the first encoding result. In this way, encoding the encoding position information of the first target keyframe determined by the difference between the position of the first target keyframe and the position of the second target keyframe can reduce data redundancy relative to encoding the difference information between the position of the keyframe and the effect position, thereby improving the encoding efficiency.

## BRIEF DESCRIPTION OF THE DRAWINGS

FIG. 1 is a schematic diagram of an encoder framework in a related technology;
FIG. 2 is a schematic diagram of a haptic signal in a related technology;
FIG. 3 is a flowchart of a method for encoding haptic data provided in an embodiment of this application;
FIG. 4 is a schematic diagram of haptic data encapsulation provided in an embodiment of this application;
FIG. 5 is a flowchart of a method for decoding haptic data provided in an embodiment of this application;
FIG. 6 is a schematic structural diagram of an apparatus for encoding haptic data provided in an embodiment of this application;
FIG. 7 is a schematic structural diagram of an apparatus for decoding haptic data provided in an embodiment of this application;
FIG. 8 is a schematic structural diagram of a communication device provided in an embodiment of this application; and
FIG. 9 is a schematic structural diagram of a terminal provided in an embodiment of this application.

## DETAILED DESCRIPTION

The following clearly describes the technical solutions in the embodiments of this application with reference to the accompanying drawings in the embodiments of this application. Apparently, the described embodiments are merely some rather than all of the embodiments of this application. All other embodiments obtained by those of ordinary skill in the art based on the embodiments of this application fall within the protection scope of this application.

In this application, the terms such as "first" and "second" are used for distinguishing similar objects, instead of describing a specific sequence or order. It is to be understood that the terms used in this way are exchangeable where appropriate, so that the embodiments of this application may be implemented in a sequence other than those illustrated or described herein. Moreover, objects distinguished by "first" and "second" are generally of the same class, and the number of the objects is not limited. For example, one or more first objects may be provided. In addition, "or" in this application indicates at least one of connected objects. For example, "A or B" covers three solutions, that is, solution I: including A and excluding B; solution II: including B and excluding A; and solution III: including both A and B. The character "/" generally indicates an "or" relationship between the associated objects.

The term "indication" in this application may be a direct indication (or explicit indication) or an indirect indication (or implicit indication). The direct indication may be understood as that a sender clearly informs a receiver of specific information, operations needing to be executed, or request results in the sent indication. The indirect indication may be understood as that the receiver determines the corresponding information according to the indication sent by the sender, or makes a judgment and determines operations needing to be executed, or request results according to the judgment result.

The encoding and decoding ends corresponding to the methods for encoding and decoding haptic data in the embodiments of this application may be a terminal. The terminal may also be referred to as a terminal device or user equipment (User Equipment, UE). The terminal may be a mobile phone, a tablet personal computer (Tablet Personal Computer), a laptop computer (Laptop Computer) or referred to as a notebook computer, a personal digital assistant (Personal Digital Assistant, PDA), a palmtop computer, a netbook, an ultra-mobile personal computer (ultra-mobile personal computer, UMPC), a mobile Internet device (Mobile Internet Device, MID), an augmented reality (augmented reality, AR)/virtual reality (virtual reality, VR) device, a robot, a wearable device (Wearable Device) or vehicle user equipment (Vehicle User Equipment, VUE), pedestrian user equipment (Pedestrian User Equipment, PUE), and other terminal-side devices. The wearable device includes: a smart watch, a smart bracelet, smart headphones, smart glasses, and the like. It is to be noted that a specific type of the terminal is not limited in the embodiments of this application.

For ease of understanding, some contents involved in the embodiments of this application are described below:

Haptics provide additional entertainment and sensory immersion experience for a user. Therefore, interaction of skillfully adding the haptic information to the content such as an audio, a video, or a game may be considered. In this way, the user experience and feeling of the media content may be significantly enhanced. In the last several years, with the increasing market importance of haptics in consumer peripheral devices (such as a device equipped with a taptic engine (Taptic Engine) and a device equipped with a dualsense (DualSense) controller), haptic encoding has become increasingly important. Haptic digital encoding stores haptic data in a digital format. Similar to audios and videos, digital encoding is crucial to the operation of a digital haptic device. A previous generation of haptic peripherals is based on a haptic actuator with poor expressiveness, and this type of actuator is generally based on a state machine control process. In addition, the current market and technical environment are highly fragmented, and various technology manufacturers develop and use a large number of different haptic encoding formats. This causes some cross-platform compatibility and interoperability problems, and these problems prevent the haptic technology from being widely applied to the market. To solve the above problems, the ongoing haptic standardization work performed by a moving picture experts group (Moving picture experts group, MPEG) emphasizes the necessity of standardizing a haptic encoding representation. A standard haptic encoding format (and a related standard decoder) helps to integrate a haptic technology into the ISOBMFF, MPEG-DASH, and MPEG-I standards, so that content creators and media/streaming media content providers can more easily integrate the haptic technology in a standardized manner, thereby improving the overall user experience.

In the field of haptics, two different representation methods are generally used for signal encoding. 1. Quantization: This type of representation is generally made based on measurement data. A sample of an original haptic phenomenon is stored in a file at a specific collection frequency to represent the signal. An example in which a haptic signal is quantized is implemented by using a WAV file originally developed for audios. The WAV file format can capture real-world data and represent complex wide-spectrum haptic feedback. A disadvantage of this type of haptic encoding is that once encoded, it is difficult to modify because a primitive used for creating a signal cannot be accessed. 2. Descriptive: This representation is used for encoding a haptic signal as a combination of primitives to be able to synthesize haptic signals. Vectorization formats in the related technology are respectively AHAP and IVS. An advantage of these formats is that they are created by a combination of primitives. They can be easily modified by an application program and a dedicated program during operation. Currently, these solutions only support vibratory haptic perception, and do not support haptics in other forms such as kinesthesis, temperature, and texture. As the complexity of signals increases, the memory efficiency of the signals is usually low, and an aperiodic phenomenon cannot be encoded.

The MPEG haptic encoding standardization describes an encoding representation of haptic media in detail, and covers the two most common haptic senses used in current devices: vibratory haptics and kinesthesis. This encoding representation allows descriptive and quantized data to be encoded in a human readable JSON format (.hjif) used as an interchange format. The format may be compressed into a binary file format (.hmpg) for distribution or compressed into a packetized bit stream (MIHS) for streaming processing. This encoding representation method can satisfy market expectations for descriptive and quantization format compatibility, and interoperability between devices, so as to implement 3D immersive experience and haptic data distribution.

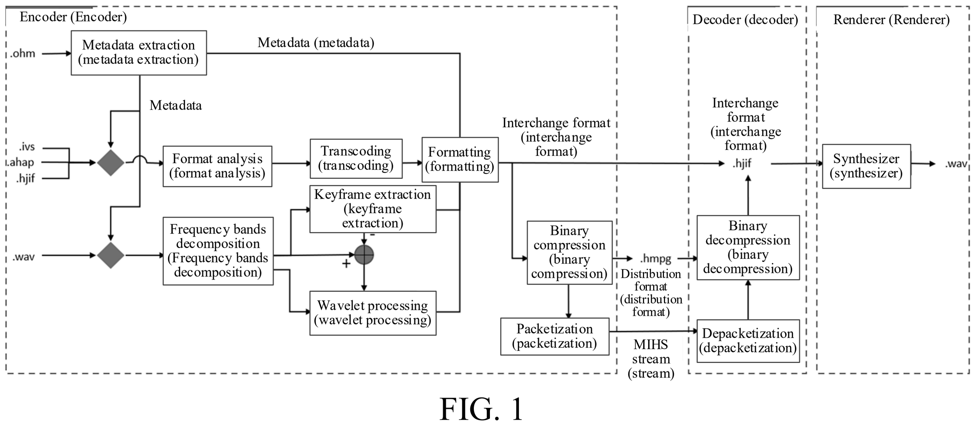

As shown in FIG. 1, an MPEG haptic encoder may process a waveform pulse code modulation (Pulse Code Modulation, PCM) signal and a descriptive haptic file (such as AHAP, IVS, or HJIF in an MPEG format). The metadata information is provided to a codec by using an OHM input file. The encoder processes two types of input files in different manners. For descriptive content, semantic analysis is performed on an input to transcode (if necessary) data into a suggested encoding representation. For PCM content, a signal analysis process is divided into two sub-processes. After band decomposition is performed on the signal, low frequencies are encoded by using a keyframe extraction process. Then, a low-frequency band is reconstructed, and a residual between the signal and an original low-frequency signal is calculated. Finally, the residual signal is added to an original high-frequency band, and encoding is performed by wavelet transform.

The MPEG defines four types of haptic bands (Haptic Bands): transient bands (Transient bands), curve bands (Curve bands), vectorial wave bands (Vectorial Wave bands), and wavelet wave bands (Wavelet Wave bands). Each band is composed of a series of "effects (Effects)" of a same type as that of the band, and each effect is defined by a "keyframes (Keyframes)" list.

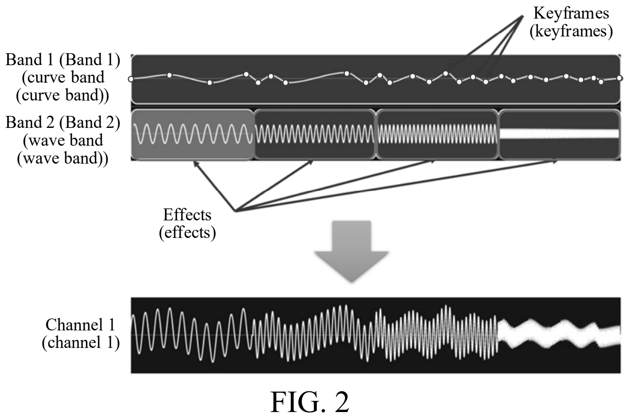

For example, as shown in FIG. 2, a haptic signal (Channel 1) is divided into a high-frequency band (such as a wave band (Wave band)) and a low-frequency band (such as a curve band (Curve band)). Exemplarily, a keyframe is extracted from a low-frequency signal (for example, a curve band) in FIG. 2, and the content of the keyframe is analyzed in a time domain. The keyframe may be extracted by using a local extremum extraction algorithm. The local extremum extraction algorithm extracts the time and amplitude of extremum points, and then, each encoded point among the extremum points is used as a keyframe, so as to form a keyframe list for describing the current effect.

Syntactic and semantic definitions included in different types of haptic bands, effects, and keyframes are shown in Table 1 to Table 5.

Table (Table) 1. Syntax of readEffect()

| Syntax | No. of bits | Mnemonic |
|---|---|---|
| readEffect() { | | |
|    id; | 16 | uimsbf |
|    effectType; | 1 | uimsbf |

| Syntax | No. of bits | Mnemonic |
|---|---|---|
| **effectPosition**; | **25** | **imsbf** |
| if (effectType == 0) { | | |
| readEffectBasis(); | | |
| } | | |
| } | | |

where Syntax of readEffect() indicates a syntactic rule of readEffect();
Id represents an ID of an effect;
effectType represents a type of an effect; and
effectPosition represents an effect position of a data packet timestamp relative to time data.

Table 2. Syntax of readEffectBasis()

| Syntax | No. of bits | Mnemonic |
|---|---|---|
| readEffectBasis() { | | |
| **keyframesCount**; | **16** | **uimsbf** |
| if (bandType == 2) { | | |
| **phase**; | **16** | **decimal** |
| **baseSignal**; | **4** | **uimsbf** |
| } | | |
| for (i = 0; i < keyframesCount; i++) { | | |
| readKeyframe(); | | |
| } | | |
| } | | |

where Syntax of readEffectBasis() indicates a syntactic rule of readEffectBasis(); and
keyframesCount represents a number of keyframes belonging to a current effect in a data packet.

Table 3. Syntax of readKeyframe()

| Syntax | No. of bits | Mnemonic |
|---|---|---|
| readKeyframe() { | | |
| if (bandType == 0) { | | |
| readTransientKeyframe(); | | |
| } else if (bandType == 1) { | | |

```
        readCurveKeyframe();
    } else if (bandType == 2) {
        readVectorialKeyframe();
    }
}
```

Table 4. Syntax of readTransientKeyframe()

| Syntax | No. of bits | Mnemonic |
|---|---|---|
| readTransientKeyframe() { | | |
| amplitude; | 8 | decimal |
| position; | 16 | uimsbf |
| frequency; | 16 | uimsbf |
| } | | |

where Syntax of readKeyframe() indicates a syntactic rule of readKeyframe();
Syntax of readTransientKeyframe() indicates a syntactic rule of readTransientKeyframe();
amplitude represents an amplitude of a keyframe;
position represents a keyframe position relative to an effect position; and
frequency represents a frequency of a keyframe.

Table 5. Syntax of readCurveKeyframe()

| Syntax | No. of bits | Mnemonic |
|---|---|---|
| readCurveKeyframe() { | | |
| amplitude; | 8 | decimal |
| position; | 16 | uimsbf |
| } | | |

where Syntax of readCurveKeyframe() indicates a syntactic rule of readCurveKeyframe();
amplitude represents an amplitude of a keyframe;
position represents a keyframe position relative to an effect position.

It is to be noted that in the related technology, when position information of a keyframe of an effect is encoded, a keyframe position relative to an effect position is encoded, resulting in relatively large data redundancy and relatively low encoding efficiency. Embodiments of this application provide a method for encoding haptic data, a method for decoding haptic data, and related devices, so as to solve the problem of relatively low encoding efficiency.

The method for encoding haptic data, the method for decoding haptic data, and the related devices provided in the embodiments of this application will be described in detail below with reference to the accompanying drawings and through some embodiments and application scenarios thereof.

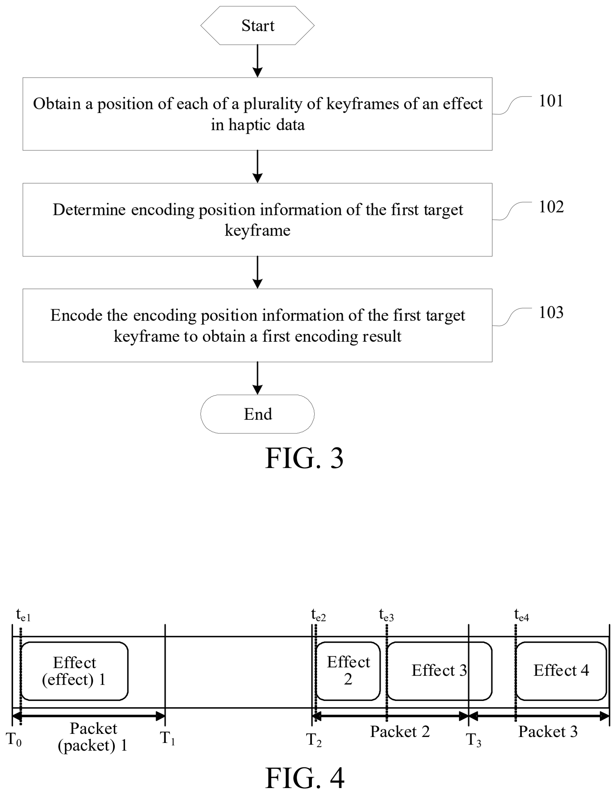

Referring to FIG. 3, FIG. 3 is a flowchart of a method for encoding haptic data provided in an embodiment of this application. The method may be applied to an encoding side. As shown in FIG. 3, the method for encoding haptic data includes the following steps:

Step 101: A position of each of a plurality of keyframes of an effect in haptic data is obtained, where the plurality of keyframes include a first target keyframe and a second target keyframe, and the second target keyframe is a keyframe located before the first target keyframe.

The haptic data may also be described as a haptic signal. The haptic data includes a plurality of effects (Effects). Exemplarily, the plurality of keyframes may be represented in a form of a keyframe list, and the keyframe list includes a plurality of keyframes.

In addition, a position of a keyframe may refer to time information of the keyframe in an effect.

Step 102: Encoding position information of the first target keyframe is determined, where the encoding position information of the first target keyframe is determined according to a difference between a position of the first target keyframe and a position of the second target keyframe.

The first target keyframe may be a keyframe in the plurality of keyframes other than a third target keyframe, and the third target keyframe is a first keyframe of the effect. Exemplarily, the first target keyframe may be any keyframe in the plurality of keyframes other than the third target keyframe.

In addition, the second target keyframe may be a closest keyframe before the first target keyframe in the plurality of keyframes; or, the second target keyframe may be any keyframe before the first target keyframe in the plurality of keyframes. Exemplarily, the plurality of keyframes of the current effect include N keyframes, the first target keyframe is an $m^{th}$ keyframe, and the second target keyframe may be any one of the first keyframe to the $(m-1)^{th}$ keyframe, where m is an integer greater than 1 and less than N, and N is a positive integer.

In an implementation, the plurality of keyframes of the effect include N keyframes, the first target keyframe is an $m^{th}$ keyframe, and the second target keyframe is an $(m-n)^{th}$ keyframe, where n is an integer greater than or equal to 1 and less than or equal to m-1. The method may further include: position information of first n keyframes of the effect is encoded to obtain a third encoding result. An encoding result of the haptic data further includes the third encoding result.

In addition, the encoding position information of the first target keyframe may be a difference between the position of the first target keyframe and the position of the second target keyframe, or may be a difference between the position of the second target keyframe and the position of the first target keyframe, or may be a value obtained by calculating, by using a preset algorithm, a difference between the position of the first target keyframe and the position of the second target keyframe, or may be a value obtained by calculating, by using a preset algorithm, a difference between the position of the second target keyframe and the position of the first target keyframe. This is not limited in this embodiment. The encoding position information of the first target keyframe may be considered as relative position information of the position of the first target keyframe relative to the position of the second target keyframe. In terms of an effect of a time sequence, the position information is time information, and the encoding position information of the first target keyframe may be difference information between a time position of the first target keyframe and a time position of the second target keyframe. Exemplarily, the encoding position information of the first target keyframe may be a difference between the time position of the first target keyframe and the time position of the second target keyframe, or may be a difference between the time position of the second target keyframe and the time position of the first target keyframe. This is not limited in this embodiment.

It is to be noted that the encoding position information of the first target keyframe may be used as position information of the first target keyframe.

Step 103: The encoding position information of the first target keyframe is encoded to obtain a first encoding result.

The encoding result of the haptic data includes the first encoding result.

The encoding result of the haptic data may also be described as a code stream of the haptic data.

In addition, a first bit number may be determined, and the first bit number is determined based on the encoding position information corresponding to the plurality of keyframes. The encoding position information of the first target keyframe is encoded by using the first bit number as an encoding bit number to obtain a first encoding result; or, the encoding position information of the first target keyframe may be encoded by using a preset encoding bit number to obtain a first encoding result. Exemplarily, the preset encoding bit number may be 16 bits, or the preset encoding bit number may be another value. This is not limited in this embodiment.

It is to be noted that position information of each keyframe (keyframe) in a current effect (effect) is a value relative to a current effect position (effect position). This position information encoding method has relatively large data redundancy. An embodiment of this application provides a method for encoding keyframe position information. Compared with MPEG encoding of relative positions of each keyframe and an effect (effect) position in the related technology, in this embodiment, a relative value of a position of each keyframe and a position of a previous keyframe is encoded, so that the bit number required by encoding position information can be reduced, thereby improving the compression efficiency of a haptic signal. Exemplarily, an effect position is 0 s, and a position of a first keyframe of the effect is the same as the effect position and is also 0 s; and a position of a second keyframe is 5 s, a position of a third keyframe is 15 s, and a position of a fourth keyframe is 30 s. If the relative positions of each keyframe and the effect position are encoded, the encoding position information corresponding to the second keyframe to the fourth keyframe is respectively 5, 15, and 30. According to the solution in this embodiment, by using encoding a relative value of a position of each keyframe and a position of a previous closest keyframe as an example, the encoding position information corresponding to the second keyframe to the fourth keyframe is respectively 5, 10, and 15. The encoding position information obviously decreases, and the bit number required by the encoding position information can be reduced, thereby reducing the data redundancy and improving the compression efficiency of the haptic data.

In the embodiments of this application, the position of each of the plurality of keyframes of the effect in the haptic data is obtained, where the plurality of keyframes include the first target keyframe and the second target keyframe, and the second target keyframe is the keyframe located before the first target keyframe; the encoding position information of the first target keyframe is determined, where the encoding position information of the first target keyframe is determined according to a difference between the position of the first target keyframe and the position of the second target keyframe; and the encoding position information of the first target keyframe is encoded to obtain the first encoding result, where the encoding result of the haptic data includes the first encoding result. In this way, encoding the encoding position information of the first target keyframe determined by the difference between the position of the first target keyframe and the position of the second target keyframe can reduce data redundancy relative to encoding the encoding position information between the position of the keyframe and the effect position, thereby improving the encoding efficiency.

Optionally, the second target keyframe is a keyframe located before the first target keyframe and closest to the first target keyframe.

The second target keyframe may be a previous keyframe of the first target keyframe. Using an example in which the first target keyframe is an $m^{th}$ keyframe, the second target keyframe may be an $(m-1)^{th}$ keyframe.

In this implementation, the second target keyframe is a keyframe located before the first target keyframe and closest to the first target keyframe. By encoding a relative value of a position of a keyframe and a position of a previous keyframe, the data redundancy can be further reduced, and the encoding efficiency can be improved.

Optionally, after the determining encoding position information of the first target keyframe, the method further includes:

determining a first bit number, where the first bit number is determined based on encoding position information corresponding to each of the plurality of keyframes.

The encoding the encoding position information of the first target keyframe to obtain a first encoding result includes:

encoding the encoding position information of the first target keyframe by using the first bit number as an encoding bit number to obtain a first encoding result.

A maximum value of the encoding position information corresponding to the plurality of keyframes may be determined, and an encoding bit number required by the maximum value is determined as the first bit number; or, a maximum value of the encoding position information corresponding to the plurality of keyframes may be determined, and a sum of an encoding bit number required by the maximum value and a preset bit number is determined as the first bit number. The preset bit number may be 1, 2, 3, or the like. The preset bit number is not limited in this embodiment.

Using an example in which the first bit number is 15, the bit number of the first encoding result obtained by encoding the encoding position information of the first target keyframe by using the first bit number is 15.

It is to be noted that in the related technology, the MPEG encodes the position information of the keyframe by using fixed 16 bits. However, in this embodiment, a bit number required for encoding the position information of the keyframe corresponding to each effect (effect) is obtained instead of using fixed 16 bits, so that a more reasonable encoded bit number can be adaptively allocated.

In this implementation, a first bit number is determined, and the first bit number is determined based on the encoding position information corresponding to each of the plurality of keyframes. The encoding position information of the first target keyframe is encoded by using the first bit number as an encoding bit number to obtain a first encoding result. In this way, a bit number required for encoding the position information of the keyframe corresponding to each effect (Effect) is obtained. Compared with encoding all effects by using a fixed bit number, a more reasonable encoding bit number can be adaptively allocated, thereby further reducing the data redundancy and improving the encoding efficiency.

Optionally, the determining a first bit number includes:

determining a maximum value of the encoding position information corresponding to the plurality of keyframes; and determining an encoding bit number required by the maximum value as the first bit number.

The encoding position information corresponding to all of the plurality of keyframes may be calculated, and an encoding bit number required by the maximum value of the encoding position information is determined as the first bit number; or the encoding position information corresponding to the remaining keyframes other than the first keyframe in the plurality of keyframes may be calculated, and an encoding bit number required by the maximum value of the encoding position information is determined as the first bit number. Exemplarily, the plurality of keyframes include a first keyframe to a fourth keyframe, and the encoding position information corresponding to the second keyframe to the fourth keyframe is respectively 5, 10, and 15, so that the maximum value of the encoding position information is 15, the first bit number is an encoding bit number required by the maximum value, and the first bit number is 4.

In an implementation, a bit number $B_k$ required for encoding the maximum value of the encoding position

information:

$$B_k = \lceil \log_2(\max\{p_i - p_{i-1}\}) \rceil,$$

where $P_i$ indicates a position of an $i^{th}$ keyframe, and $i$ is greater than 0; $\lceil ... \rceil$ indicates rounding up; $B_k$ indicates a bit number (that is, a first bit number) required by the encoding position information of a keyframe of a $k^{th}$ effect (that is, a current effect); and $p_{i-1}$ indicates a position of an $(i-1)^{th}$ keyframe, and the $(i-1)^{th}$ keyframe is a closest keyframe before the $i^{th}$ keyframe.

In this implementation, the maximum value of the encoding position information corresponding to the plurality of keyframes is determined; and the encoding bit number required by the maximum value is determined as the first bit number, so that the determined first bit number can have a minimum value when encoding of the encoding position information is satisfied, thereby adaptively allocating an encoding bit number to each effect.

Optionally, the encoding result of the haptic data further includes the first bit number.

The first bit number may be written into a code stream as metadata. Exemplarily, the first bit number may be written into a Haptic Effect data structure. For example, the first bit number may be written into readEffect(), or may be written into readEffectBasis(), or another position. This is not limited in this embodiment.

In this implementation, the encoding result of the haptic data further includes the first bit number. The first bit number is an encoding bit number for encoding the encoding position information of the first target keyframe, so that a decoding side can decode the first encoding result in the encoding result of the haptic data by using the first bit number carried in the encoding result of the haptic data to obtain the encoding position information of the first target keyframe.

Optionally, the first target keyframe is a keyframe in the plurality of keyframes other than a third target keyframe, and the third target keyframe is a first keyframe of the effect.

The method further includes:
encoding encoding position information of the third target keyframe to obtain a second encoding result.

The encoding result of the haptic data further includes the second encoding result.

In this implementation, the third target keyframe is the first keyframe of the effect, and the encoding position information of the third target keyframe is encoded to obtain a second encoding result. The encoding result of the haptic data further includes the second encoding result, so that the decoding side can decode the second encoding result to obtain the encoding position information of the first keyframe of the effect, and further can calculate a position of each keyframe according to the encoding position information of the first keyframe and the encoding position information corresponding to each keyframe.

Optionally, the encoding encoding position information of the third target keyframe to obtain a second encoding result includes:

determining the second encoding result as a preset value in a case that a position of the third target keyframe is the same as an effect position of the effect; or
encoding the encoding position information of the third target keyframe based on a preset encoding bit number in a case that the position of the third target keyframe is different from the effect position of the effect to obtain the second encoding result.

In a case that the position of the third target keyframe is the same as the effect position of the effect, it may be determined that the encoding position information of the third target keyframe is a preset value (for example, 0 or 1), and the encoding position information of the third target keyframe is encoded by using one bit to obtain the second encoding result. The second encoding result is the preset value.

In addition, the preset encoding bit number may be 16 bits, or the preset encoding bit number may be another value, such as 20 or 25. This is not limited in this embodiment.

In addition, the encoding position information of the third target keyframe may be determined based on a difference between the position of the third target keyframe and the effect position of the effect. Exemplarily, the encoding position information of the third target keyframe may be a difference between a position of the third target keyframe and an effect position of an effect; or, the encoding position information of the third target keyframe may be a difference between an effect position of an effect and a position of the third target keyframe; or, the encoding position information of the third target keyframe may be a value obtained by calculating, by using a preset algorithm, a difference between a position of the third target keyframe and an effect position of an effect; or, the encoding position information of the third target keyframe may be a value obtained by calculating, by using a preset algorithm, a difference between an effect position of an effect and a position of the third target keyframe. This is not limited in this embodiment.

In this implementation, the second encoding result is determined as a preset value in a case that the position of the third target keyframe is the same as the effect position of the effect; or, the encoding position information of the third target keyframe is encoded based on a preset encoding bit number in a case that the position of the third target keyframe is different from the effect position of the effect to obtain the second encoding result, thereby encoding the position of the first keyframe of the effect.

Optionally, the first target keyframe is a keyframe in the plurality of keyframes other than a third target keyframe, the third target keyframe is the first keyframe of the effect, and the first bit number is determined based on the encoding position information corresponding to a keyframe in the plurality of keyframes other than the third target keyframe.

The encoding the encoding position information of the first target keyframe by using the first bit number as an encoding bit number to obtain a first encoding result includes:

  determining a second bit number in a case that the position of the third target keyframe is different from the effect position of the effect, where the second bit number represents an encoding bit number required for encoding the encoding position information of the third target keyframe;

  updating the first bit number to the second bit number in a case that the second bit number is greater than the first bit number; and

  encoding the encoding position information of the first target keyframe by using the updated first bit number as an encoding bit number to obtain a first encoding result.

The first bit number is updated to a value of the second bit number in a case that the second bit number is greater than the first bit number; and the first bit number may be kept unchanged in a case that the second bit number is less than or equal to the first bit number, so that a maximum value of the first bit number or the second bit number is used as the updated first bit number.

Exemplarily, the second bit number may be calculated as follows:

$$ B0_k = \left\lceil \log_2 p_0' \right\rceil, $$

where $p_0'$ is encoding position information of the third target keyframe, and $B0_k$ indicates a bit number (that is, the second bit number) required for encoding the encoding position information of the third target keyframe of the $k^{th}$ effect (that is, the current effect).

In addition, a maximum value of the encoding position information corresponding to a keyframe in the plurality of keyframes other than the third target keyframe may be determined, and an encoding bit number required by the maximum value is determined as the first bit number.

In this implementation, a second bit number is determined, and the second bit number represents an encoding bit number required for encoding the encoding position information of the third target keyframe; the first bit number is updated to a value of the second bit number in a case that the second bit number is greater than the first bit number; and for encoding of the encoding position information of the first target keyframe, the updated first bit number is used as an encoding bit number, so that the decoding side may decode positions of all keyframes of a same effect by using a same decoding bit number to obtain relatively high decoding efficiency.

Optionally, the method further includes:
encoding the encoding position information of the third target keyframe by using the updated first bit number as an encoding bit number to obtain a second encoding result.

The encoding result of the haptic data further includes the second encoding result.

In this implementation, for encoding of the encoding position information of the first target keyframe and the encoding position information of the third target keyframe, the updated first bit number is used as an encoding bit number, so that the decoding side may decode positions of all keyframes of a same effect by using a same decoding bit number to obtain relatively high decoding efficiency.

Optionally, in a case that different keyframes of the effect are respectively located in a first data packet and a second data packet and a keyframe before a fourth target keyframe is located in the first data packet, encoding position information of the fourth target keyframe is determined according to a difference between a position of the fourth target keyframe and a start time position of the second data packet, or the encoding position information of the fourth target keyframe is determined according to a difference between the position of the fourth target keyframe and the effect position of the effect.

The fourth target keyframe is a first keyframe in the second data packet, and the first target keyframe is a keyframe in the plurality of keyframes other than the fourth target keyframe.

In an implementation, the method may further include: encoding the encoding position information of the fourth target keyframe to obtain a fourth encoding result. The encoding result of the haptic data further includes the fourth encoding result.

Exemplarily, when the haptic data is encapsulated, a situation shown in FIG. 4 occurs. The Effect 3 is encapsulated in two Packets (Packet 2 and Packet 3). In this case, for the first keyframe (that is, the fourth target keyframe) located after the T3 moment of Effect 3 in Packet 3, a calculation method of position information $p_i'$ of the fourth target keyframe may be any one of the following methods.

Method I: The encoding position information $p_i' = p_i - p_{i-1}$ of the fourth target keyframe is still calculated according to the method described in step 101 to step 103. In this case, $p_{i-1}$ is the last frame of Effect 3 located in Packet 2.

Method II: $p_i' = p_i - T_3$. $T_3$ is a timestamp (Timestamp) of Packet 3.

Method III: $p_i' = p_i - t_{e3}$. $t_{e3}$ is a position of Effect 3 ($Ep_k$).

In this implementation, in a case that different keyframes of the effect are respectively located in a first data packet and a second data packet and a keyframe before the fourth target keyframe is located in the first data packet, the encoding position information of the fourth target keyframe is determined according to a difference between a position of the fourth target keyframe and a start time position of the second data packet, so that the decoding side can determine the position of the fourth target keyframe according to the start time position of the second data packet and the encoding position information of the fourth target keyframe.

In this implementation, in a case that different keyframes of the effect are respectively located in a first data packet and a second data packet and a keyframe before the fourth target keyframe is located in the first data packet, the encoding position information of the fourth target keyframe is determined according to a difference between a position of the fourth target keyframe and an effect position of the effect, so that the decoding side can determine the position of the fourth target keyframe according to the start time position of the effect and the encoding position information of the fourth target keyframe.

Optionally, the obtaining a position of each of a plurality of keyframes of an effect in haptic data includes: obtaining a keyframe list of the effect in the haptic data, where the keyframe list includes positions of the plurality of keyframes, and the positions of the plurality of keyframes are arranged in chronological order.

Optionally, the keyframe list further includes a keyframe identifier corresponding to the position of a keyframe.

An embodiment of this application further provides a method for encoding haptic data, including the following processes:

The encoding position information of the fourth target keyframe is encoded to obtain a fourth encoding result. The encoding result of the haptic data includes the fourth encoding result.

The fourth target keyframe is a keyframe in a plurality of keyframes of an effect in the haptic data.

In a case that different keyframes of the effect are respectively located in a first data packet and a second data packet and a keyframe before the fourth target keyframe is located in the first data packet, the encoding position information of the fourth target keyframe is determined according to a difference between a position of the fourth target keyframe and a start time position of the second data packet, or, the encoding position information of the fourth target keyframe is determined according to a difference between a position of the fourth target keyframe and the effect position of the effect.

The fourth target keyframe is the first keyframe in the second data packet.

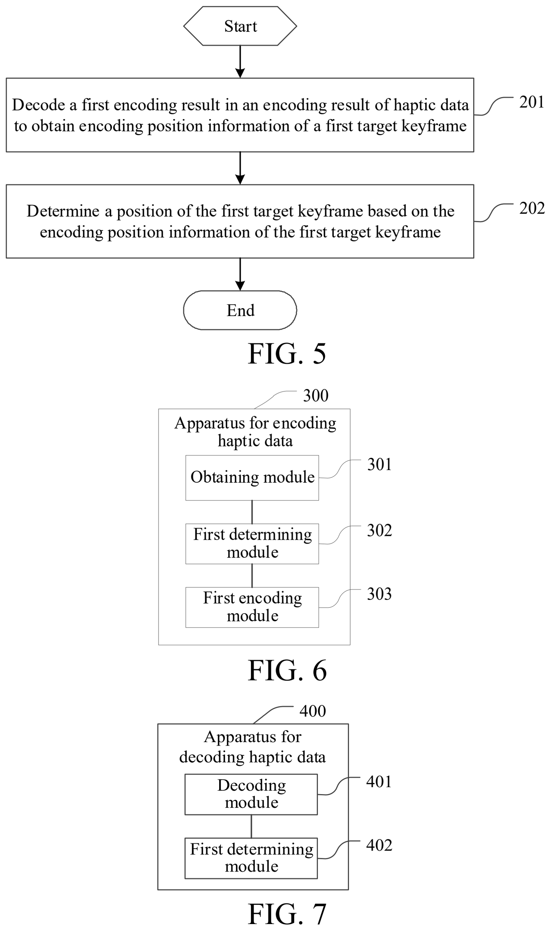

Referring to FIG. 5, FIG. 5 is a flowchart of a method for decoding haptic data provided in an embodiment of this application. The method may be applied to a decoding side. As shown in FIG. 5, the method for decoding haptic data includes the following steps:

Step 201: A first encoding result in the encoding result of haptic data is decoded to obtain encoding position information of a first target keyframe, where the encoding position information corresponding to the first target keyframe is determined according to a difference between a position of the first target keyframe and a position of a second target keyframe, the first target keyframe and the second target keyframe are keyframes in a plurality of keyframes of an effect in the haptic data, and the second target keyframe is a keyframe located before the first target keyframe.

Step 202: The position of the first target keyframe is determined based on the encoding position information of the first target keyframe.

Optionally, the second target keyframe is a keyframe located before the first target keyframe and closest to the first target keyframe.

Optionally, the decoding a first encoding result in the encoding result of haptic data to obtain encoding position information of a first target keyframe includes:

decoding the first encoding result in the encoding result of the haptic data based on a first bit number to obtain the encoding position information of the first target keyframe.

The first bit number is an encoding bit number for encoding the encoding position information of the first target keyframe.

Optionally, the encoding result of the haptic data further includes the first bit number, and the first bit number is determined based on encoding position information corresponding to each of the plurality of keyframes.

Optionally, the first bit number is an encoding bit number required by a maximum value of the encoding position information corresponding to the plurality of keyframes.

Optionally, the encoding result of the haptic data further includes a second encoding result. The first target keyframe is a keyframe in the plurality of keyframes other than a third target keyframe. The third target keyframe is the first keyframe of the effect. The method further includes:

determining a position of the third target keyframe based on the second encoding result.

Optionally, the determining a position of the third target keyframe based on the second encoding result includes:

determining that the position of the third target keyframe is the same as the effect position of the effect in a case that the second encoding result is a preset value; or

decoding the second encoding result based on a preset encoding bit number in a case that the second encoding result is not the preset value to obtain the encoding position information of the third target keyframe; and determining the position of the third target keyframe based on the encoding position information of the third target keyframe.

It is to be noted that this embodiment is used as an implementation on a decoding side corresponding to the embodiment shown in FIG. 3. For a specific implementation, refer to related descriptions of the embodiment shown in FIG. 3. To avoid repeated descriptions, details are not described in this embodiment again, and the same beneficial effects can be achieved.

The method for encoding haptic data and the method for decoding haptic data in the embodiments of this application are described below through two specific embodiments.

Embodiment 1:

For an encoding side, the method for encoding haptic data may include the following processes:

Step 11: A keyframe list of a current effect is obtained.

Step 12: A difference (the difference is greater than zero) between a position of each keyframe in the keyframe list other than the first keyframe and a position of a previous keyframe is sequentially calculated to obtain a maximum difference, and a bit number $B_k$ required for encoding the maximum difference is calculated:

$$B_k = \lceil \log_2(\max\{p_i - p_{i-1}\}) \rceil,$$

where Pi indicates a position of an $i^{th}$ keyframe, and i is greater than 0; $\lceil \cdots \rceil$ indicates rounding up; $B_k$ indicates a bit number required for encoding the position information of a keyframe of a $k^{th}$ effect (that is, the current effect); and $p_{i-1}$ indicates a position of an $(i-1)^{th}$ keyframe, and the $(i-1)^{th}$ keyframe is a closest keyframe before the $i^{th}$ keyframe.

Step 13: A bit number $B_k$ required for encoding the position information of the keyframe corresponding to the current effect is written into a code stream as metadata. It is to be noted that, $B_k$ may be written into a Haptic Effect data structure, for example, may be written into readEffect(), or may be written into readEffectBasis(), or another position. This is not limited here.

Step 14: The position information $p_0'$ of the first keyframe is encoded and written into the code stream. The position information $p_0'$ of the first keyframe is a relative value (that is, a difference) between the position $p_0$ of the first keyframe and the position information $Ep_k$ of the current effect.

It is to be noted that according to different actual haptic data code stream encapsulation methods, the position of the first keyframe in the current effect may be the same as or different from the current effect position. Therefore, the position information of the first keyframe may be encoded by the following several methods which are not limited here.

Method I: If the position of the first keyframe is the same as the current effect position, $p_0'$ is 0, and $p_0'$ is encoded with 1 bit.

Method II: If the position of the first keyframe is different from the current effect position, $p_0'$ is encoded by 16 bits specified by the MPEG in the related technology.

Method III: If the position of the first keyframe is different from the current effect position, first, a bit number $B0_k$ required for encoding $p_0'$ is calculated:

$$ B0_k = \left\lceil \log_2 p_0' \right\rceil, $$

Then, $B0_k$ and $B_k$ calculated in step 12 are compared. If $B0_k$ is greater than $B_k$, $B_k$ is updated to $B0_k$, and $p_0'$ and $p_i'$ are encoded by using the updated bit number $B_k$. If $B0_k$ is less than $B_k$, $B_k$ remains unchanged, and $p_0'$ and $p_i'$ are encoded by using $B_k$.

Step 15: The position information $p_i'$ of each keyframe other than the first keyframe (that is, the encoding position information corresponding to each keyframe) is encoded by using the $B_k$ bit number determined in step 12 and written into the code stream. The position information of each keyframe is a difference between a position of a current keyframe and a position of a previous keyframe, that is:

$$ p_i' = p_i - p_{i-1}, i > 0. $$

Embodiment 2:

For a decoding side, the method for decoding haptic data may include the following processes:
Step 21: A bit number $B_k$ required for encoding the position information of the keyframe of the current effect is obtained.

Step 22: The position information $Ep_k$ of the current effect is obtained, the position information $p_0'$ of the first keyframe in the current effect is decoded, and the position $p_0$ of the first keyframe is calculated:

$$ p_0 = p_0' + Ep_k. $$

Step 23: A difference $p_i'$ between the position of each keyframe other than the first keyframe and the position of the previous keyframe is decoded by using the bit number $B_k$ obtained in step 21, and the position $p_0$ of each keyframe is calculated:

$$ p_i = p_i' + p_{i-1}, $$

where i > 0.
In this embodiment, by encoding a relative value of the position of each keyframe and the position of the previous keyframe, a bit number required for encoding position information can be reduced. In addition, a bit number required for encoding position information of each key corresponding to each effect (Effect) is obtained, and a more reasonable encoding bit number can be adaptively allocated, thereby reducing the data redundancy and improving the encoding efficiency.
It is to be noted that an executive body of the method for encoding haptic data provided in this embodiment of this application may be an apparatus for encoding haptic data, or a control module configured to perform the method for encoding haptic data in the apparatus for encoding haptic data. An example in which the apparatus for encoding haptic data executes the method for encoding haptic data is used in this embodiment of this application to describe the apparatus for encoding haptic data provided in this embodiment of this application.
Referring to FIG. 6, FIG. 6 is a structural diagram of an apparatus for encoding haptic data provided in an embodiment of this application. As shown in FIG. 6, an apparatus for encoding haptic data 300 includes:

an obtaining module 301, configured to obtain a position of each of a plurality of keyframes of an effect in haptic data, where the plurality of keyframes include a first target keyframe and a second target keyframe, and the second target keyframe is a keyframe located before the first target keyframe;

a first determining module 302, configured to determine encoding position information of the first target keyframe, where the encoding position information of the first target keyframe is determined according to a difference between a position of the first target keyframe and a position of the second target keyframe; and

a first encoding module 303, configured to encode the encoding position information of the first target keyframe to obtain a first encoding result.

An encoding result of the haptic data includes the first encoding result.

Optionally, the second target keyframe is a keyframe located before the first target keyframe and closest to the first target keyframe.

Optionally, the apparatus further includes:

a second determining module, configured to determine a first bit number, where the first bit number is determined based on encoding position information corresponding to each of the plurality of keyframes.

The first encoding module is specifically configured to:

encode the encoding position information of the first target keyframe by using the first bit number as an encoding bit number to obtain a first encoding result.

Optionally, the second determining module is specifically configured to:

determine a maximum value of the encoding position information corresponding to the plurality of keyframes; and determine an encoding bit number required by the maximum value as the first bit number.

Optionally, the encoding result of the haptic data further includes the first bit number.

Optionally, the first target keyframe is a keyframe in the plurality of keyframes other than a third target keyframe, and the third target keyframe is a first keyframe of the effect.

The apparatus further includes:

a second encoding module, configured to encode encoding position information of the third target keyframe to obtain a second encoding result.

The encoding result of the haptic data further includes the second encoding result.

Optionally, the second encoding module is specifically configured to:

determine the second encoding result as a preset value in a case that a position of the third target keyframe is the same as an effect position of the effect; or

encode the encoding position information of the third target keyframe based on a preset encoding bit number in a case that the position of the third target keyframe is different from the effect position of the effect to obtain the second encoding result.

Optionally, the first target keyframe is a keyframe in the plurality of keyframes other than a third target keyframe, the third target keyframe is the first keyframe of the effect, and the first bit number is determined based on the encoding position information corresponding to a keyframe in the plurality of keyframes other than the third target keyframe.

The first encoding module is specifically configured to:

determine a second bit number in a case that the position of the third target keyframe is different from the effect position of the effect, where the second bit number represents an encoding bit number required for encoding the encoding position information of the third target keyframe;

update the first bit number to the second bit number in a case that the second bit number is greater than the first bit number; and

encode the encoding position information of the first target keyframe by using the updated first bit number as an encoding bit number to obtain a first encoding result.

Optionally, the apparatus further includes:

a third encoding module, configured to encode the encoding position information of the third target keyframe by using the updated first bit number as an encoding bit number to obtain a second encoding result.

The encoding result of the haptic data further includes the second encoding result.

Optionally, in a case that different keyframes of the effect are respectively located in a first data packet and a second data packet and a keyframe before a fourth target keyframe is located in the first data packet, encoding position information of the fourth target keyframe is determined according to a difference between a position of the fourth target keyframe and a start time position of the second data packet, or the encoding position information of the fourth target keyframe is determined according to a difference between the position of the fourth target keyframe and the effect position of the effect.

The fourth target keyframe is a first keyframe in the second data packet, and the first target keyframe is a keyframe in the plurality of keyframes other than the fourth target keyframe.

Optionally, the obtaining module is specifically configured to:
obtain a keyframe list of an effect in the haptic data, where the keyframe list includes positions of the plurality of keyframes, and the positions of the plurality of keyframes are arranged in chronological order.

The apparatus for encoding haptic data in this embodiment of this application may be an apparatus, an apparatus or an electronic device with an operating system, or a component, an integrated circuit or a chip in a terminal. The apparatus or the electronic device may be a mobile terminal or a non-mobile terminal. Exemplarily, the mobile terminal may include, but is not limited to, the type of the terminal listed above, and the non-mobile terminal may be a server, a network attached storage (Network Attached Storage, NAS), a personal computer (personal computer, PC), a television (television, TV), a teller machine, or a self-service machine. This is not specifically limited in this embodiment of this application.

The apparatus for encoding haptic data provided in this embodiment of this application can implement the processes implemented by the method embodiment in FIG. 3, and achieve the same technical effects. To avoid repetition, details are not described here again.

It is to be noted that an executive body of the method for decoding haptic data provided in this embodiment of this application may be an apparatus for decoding haptic data, or a control module configured to perform the method for decoding haptic data in the apparatus for decoding haptic data. An example in which the apparatus for decoding haptic data executes the method for decoding haptic data is used in this embodiment of this application to describe the apparatus for decoding haptic data provided in this embodiment of this application.

Referring to FIG. 7, FIG. 7 is a structural diagram of an apparatus for decoding haptic data provided in an embodiment of this application. As shown in FIG. 7, an apparatus for decoding haptic data 400 includes:

a decoding module 401, configured to decode a first encoding result in an encoding result of the haptic data to obtain encoding position information of a first target keyframe, where the encoding position information corresponding to the first target keyframe is determined according to a difference between a position of the first target keyframe and a position of a second target keyframe, the first target keyframe and the second target keyframe are keyframes in a plurality of keyframes of an effect in the haptic data, and the second target keyframe is a keyframe located before the first target keyframe; and

a first determining module 402, configured to determine the position of the first target keyframe based on the encoding position information of the first target keyframe.

Optionally, the second target keyframe is a keyframe located before the first target keyframe and closest to the first target keyframe.

Optionally, the decoding module is specifically configured to:
decode the first encoding result in the encoding result of the haptic data based on a first bit number to obtain the encoding position information of the first target keyframe.

The first bit number is an encoding bit number for encoding the encoding position information of the first target keyframe.

Optionally, the encoding result of the haptic data further includes the first bit number, and the first bit number is determined based on encoding position information corresponding to each of the plurality of keyframes.

Optionally, the first bit number is an encoding bit number required by a maximum value of the encoding position information corresponding to the plurality of keyframes.

Optionally, the encoding result of the haptic data further includes a second encoding result. The first target keyframe is a keyframe in the plurality of keyframes other than a third target keyframe. The third target keyframe is the first keyframe of the effect. The apparatus further includes:
a second determining module, configured to determine a position of the third target keyframe based on the second encoding result.

Optionally, the second determining module is specifically configured to:

determine that the position of the third target keyframe is the same as the effect position of the effect in a case that the second encoding result is a preset value; or

decode the second encoding result based on a preset encoding bit number in a case that the second encoding result is not the preset value to obtain the encoding position information of the third target keyframe; and determine the position of the third target keyframe based on the encoding position information of the third target keyframe.

The apparatus for decoding haptic data in this embodiment of this application may be an apparatus, an apparatus or an electronic device with an operating system, or a component, an integrated circuit or a chip in a terminal. The apparatus or the electronic device may be a mobile terminal or a non-mobile terminal. Exemplarily, the mobile terminal may include, but is not limited to, the type of the terminal listed above, and the non-mobile terminal may be a server, a network attached storage (Network Attached Storage, NAS), a personal computer (personal computer, PC), a television (television, TV), a teller machine, or a self-service machine. This is not specifically limited in this embodiment of this application.

The apparatus for decoding haptic data provided in this embodiment of this application can implement the processes implemented by the method embodiment in FIG. 5, and achieve the same technical effects. To avoid repetition, details are not described here again.

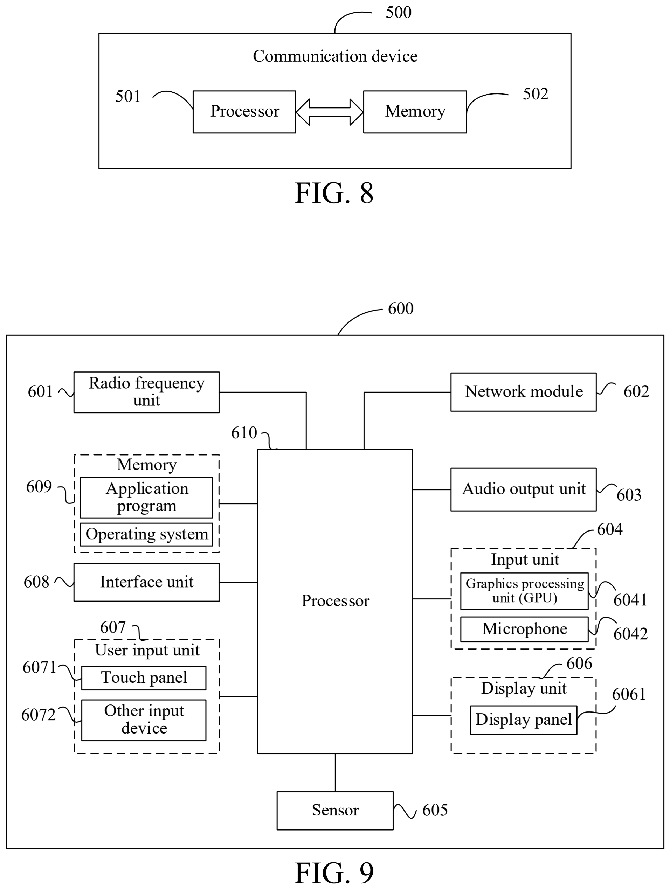

Optionally, as shown in FIG. 8, an embodiment of this application further provides a communication device 500, including a processor 501 and a memory 502. A program or instruction executable on the processor 501 is stored on the memory 502. For example, in a case that the communication device 500 is an encoding-side device, the program or instruction, when executed by the processor 501, implements the various steps of the embodiment of the above method for encoding haptic data, and can achieve the same technical effects. In a case that the communication device 500 is a decoding-side device, the program or instruction, when executed by the processor 501, implements the various steps of the embodiment of the above method for decoding haptic data, and can achieve the same technical effects. To avoid repetition, details are not described here again.

An embodiment of this application further provides a terminal, including a processor and a communication interface. The processor is configured to: obtain a position of each of a plurality of keyframes of an effect in haptic data, where the plurality of keyframes include a first target keyframe and a second target keyframe, and the second target keyframe is a keyframe located before the first target keyframe; determine encoding position information of the first target keyframe, where the encoding position information of the first target keyframe is determined according to a difference between a position of the first target keyframe and a position of the second target keyframe; and encode the encoding position information of the first target keyframe to obtain a first encoding result, where the encoding result of the haptic data includes the first encoding result. Alternatively, the processor is configured to: decode a first encoding result in an encoding result of haptic data to obtain encoding position information of a first target keyframe, where the encoding position information corresponding to the first target keyframe is determined according to a difference between a position of the first target keyframe and a position of a second target keyframe, the first target keyframe and the second target keyframe are keyframes in a plurality of keyframes of an effect in the haptic data, and the second target keyframe is a keyframe located before the first target keyframe; and determine the position of the first target keyframe based on the encoding position information of the first target keyframe. The terminal embodiment corresponds to the embodiment of the above method for encoding haptic data or the method for decoding haptic data. Each implementation process and implementation of the embodiment of the above method for encoding haptic data or the method for decoding haptic data can be applied to the terminal embodiment, and can achieve the same technical effects. Specifically, FIG. 9 is a schematic diagram of hardware structures of a terminal for implementing an embodiment of this application.

The terminal 600 includes, but is not limited to, at least part of components such as a radio frequency unit 601, a network module 602, an audio output unit 603, an input unit 604, a sensor 605, a display unit 606, a user input unit 607, an interface unit 608, a memory 609, and a processor 610.

Those skilled in the art may understand that the terminal 600 may further include a power supply (such as a battery) that supplies power to various components. The power supply may be logically connected to the processor 610 through a power management system, thus implementing functions of charging management, discharging management, and power consumption management through the power management system. A terminal structure shown in FIG. 9 does not constitute a limitation to the terminal, and the terminal may include more or fewer components than those shown in the figure, or some components may be combined, or a different component deployment may be used. Details are not repeated here.

It is to be understood that in the embodiments of this application, the input unit 604 may include a graphics processing unit (Graphics Processing Unit, GPU) 6041 and a microphone 6042. The graphics processing unit 6041 performs processing on image data of a static picture or a video that is obtained by an image obtaining apparatus (for example, a camera) in a video obtaining mode or an image obtaining mode. The display unit 606 may include a display panel 6061. The display panel 6061 may be configured by using a liquid crystal display, an organic light-emitting diode, or the like. The user input unit 607 includes at least one of a touch panel 6071 and another input device 6072. The touch panel 6071 is also referred to as a touch screen. The touch panel 6071 may include two parts: a touch detection apparatus and a touch controller. The other input device 6072 may include, but is not limited to, a physical keyboard, a functional key (such as a volume control key or a switch key), a track ball, a mouse, and a joystick. Details are not described here again.

In an embodiment of this application, after receiving downlink data from the network side device, the radio frequency unit 601 may transmit the downlink data to the processor 610 for processing. In addition, the radio frequency unit 601 may send uplink data to the network side device. Generally, the radio frequency unit 601 includes, but is not limited to, an antenna, an amplifier, a transceiver, a coupler, a low noise amplifier, a duplexer, and the like.

The memory 609 may be configured to store a software program or instruction and various data. The memory 609 may mainly include a first storage area for storing a program or an instruction, and a second storage area for storing data. The first storage area may store an operating system, at least one application program or instruction required for a function (such as a sound playback function or an image playback function), and the like. In addition, the memory 609 may include a volatile memory or a non-volatile memory, or the memory 609 may include both the volatile memory and the non-volatile memory. The non-volatile memory may be a read-only memory (Read-Only Memory, ROM), a programmable read-only memory (Programmable ROM, PROM), an erasable programmable read-only memory (Erasable PROM, EPROM), an electrically erasable programmable read-only memory (Electrically EPROM, EEPROM), or a flash memory. The volatile memory may be a random access memory (Random Access Memory, RAM), a static random access memory (Static RAM, SRAM), a dynamic random access memory (Dynamic RAM, DRAM), a synchronous dynamic random access memory (Synchronous DRAM, SDRAM), a double data rate synchronous dynamic random access memory (Double Data Rate SDRAM, DDRSDRAM), an enhanced synchronous dynamic random access memory (Enhanced SDRAM, ESDRAM), a synch link dynamic random access memory (Synch link DRAM, SLDRAM), or a direct rambus random access memory (Direct Rambus RAM, DRRAM). The memory x09 in this embodiment of this application includes, but is not limited to, these memories and any other suitable types of memories.

The processor 610 may include one or more processing units. Optionally, the processor 610 integrates an application processor and a modem processor. The application processor mainly processes operations involving an operating system, a user interface, an application program, and the like. The modem processor mainly processes wireless communication signals, for example, a baseband processor. It may be understood that the above modem processor may also not be integrated into the processor 610.

In a case that the terminal is an encoding side,

the processor 610 is configured to:
obtain a position of each of a plurality of keyframes of an effect in haptic data, where the plurality of keyframes include a first target keyframe and a second target keyframe, and the second target keyframe is a keyframe located before the first target keyframe;
determine encoding position information of the first target keyframe, where the encoding position information of the first target keyframe is determined according to a difference between a position of the first target keyframe and a position of the second target keyframe; and
encode the encoding position information of the first target keyframe to obtain a first encoding result,
where an encoding result of the haptic data includes the first encoding result.

Optionally, the second target keyframe is a keyframe located before the first target keyframe and closest to the first target keyframe.
Optionally, the processor 610 is further configured to:

determine a first bit number, where the first bit number is determined based on encoding position information corresponding to each of the plurality of keyframes; and
encode the encoding position information of the first target keyframe by using the first bit number as an encoding bit number to obtain a first encoding result.

Optionally, the processor 610 is specifically configured to:

determine a maximum value of the encoding position information corresponding to the plurality of keyframes; and
determine an encoding bit number required by the maximum value as the first bit number.

Optionally, the encoding result of the haptic data further includes the first bit number.
Optionally, the first target keyframe is a keyframe in the plurality of keyframes other than a third target keyframe, and the third target keyframe is a first keyframe of the effect.
The processor 610 is further configured to:
encode encoding position information of the third target keyframe to obtain a second encoding result,
[0171] The encoding result of the haptic data further includes the second encoding result.
Optionally, the processor 610 is specifically configured to:

determine the second encoding result as a preset value in a case that a position of the third target keyframe is the same as an effect position of the effect; or
encode the encoding position information of the third target keyframe based on a preset encoding bit number in a case that the position of the third target keyframe is different from the effect position of the effect to obtain the second encoding result.

Optionally, the first target keyframe is a keyframe in the plurality of keyframes other than a third target keyframe, the third target keyframe is the first keyframe of the effect, and the first bit number is determined based on the encoding position information corresponding to a keyframe in the plurality of keyframes other than the third target keyframe.

The processor 610 is specifically configured to:

determine a second bit number in a case that a position of the third target keyframe is different from the effect position of the effect, where the second bit number represents an encoding bit number required for encoding the encoding position information of the third target keyframe;

update the first bit number to the second bit number in a case that the second bit number is greater than the first bit number; and

encode the encoding position information of the first target keyframe by using the updated first bit number as an encoding bit number to obtain a first encoding result.

Optionally, the processor 610 is further configured to:

encode the encoding position information of the third target keyframe by using the updated first bit number as an encoding bit number to obtain a second encoding result.

The encoding result of the haptic data further includes the second encoding result.

Optionally, in a case that different keyframes of the effect are respectively located in a first data packet and a second data packet and a keyframe before a fourth target keyframe is located in the first data packet, encoding position information of the fourth target keyframe is determined according to a difference between a position of the fourth target keyframe and a start time position of the second data packet, or the encoding position information of the fourth target keyframe is determined according to a difference between the position of the fourth target keyframe and the effect position of the effect.

The fourth target keyframe is a first keyframe in the second data packet, and the first target keyframe is a keyframe in the plurality of keyframes other than the fourth target keyframe.

Optionally, the processor 610 is specifically configured to:

obtain a keyframe list of the effect in the haptic data, where the keyframe list includes positions of the plurality of keyframes, and the positions of the plurality of keyframes are arranged in chronological order.

In a case that the terminal is a decoding side,

the processor 610 is configured to:

decode a first encoding result in an encoding result of the haptic data to obtain encoding position information of a first target keyframe, where the encoding position information corresponding to the first target keyframe is determined according to a difference between a position of the first target keyframe and a position of a second target keyframe, the first target keyframe and the second target keyframe are keyframes in a plurality of keyframes of an effect in the haptic data, and the second target keyframe is a keyframe located before the first target keyframe; and

determine the position of the first target keyframe based on the encoding position information of the first target keyframe.

Optionally, the second target keyframe is a keyframe located before the first target keyframe and closest to the first target keyframe.

Optionally, the processor 610 is further configured to:

decode the first encoding result in the encoding result of the haptic data based on a first bit number to obtain the encoding position information of the first target keyframe.

The first bit number is an encoding bit number for encoding the encoding position information of the first target keyframe.

Optionally, the encoding result of the haptic data further includes the first bit number, and the first bit number is determined based on encoding position information corresponding to each of the plurality of keyframes.

Optionally, the first bit number is an encoding bit number required by a maximum value of the encoding position information corresponding to the plurality of keyframes.

Optionally, the encoding result of the haptic data further includes a second encoding result. The first target keyframe is a keyframe in the plurality of keyframes other than a third target keyframe. The third target keyframe is the first keyframe of the effect. The processor 610 is further configured to:

determine a position of the third target keyframe based on the second encoding result.

Optionally, the processor 610 is specifically configured to:

determine that the position of the third target keyframe is the same as the effect position of the effect in a case that the second encoding result is a preset value; or

decode the second encoding result based on a preset encoding bit number in a case that the second encoding result is not the preset value to obtain encoding position information of the third target keyframe; and determine the position of the third target keyframe based on the encoding position information of the third target keyframe.

Specifically, the terminal according to this embodiment of this application further includes an instruction or program stored in the memory 609 and executable on the processor 610. The processor 610 calls the instruction or program in the memory 609 to execute the method executed by each module shown in FIG. 6 or FIG. 7, and achieves the same technical effects. To avoid repetition, details are not described here.

An embodiment of this application further provides a readable storage medium. The readable storage medium stores a program or an instruction. The program or instruction, when executed by a processor, implements each process of the embodiment of the above method for encoding haptic data, or the program or instruction, when executed by a processor, implements each process of the embodiment of the above method for decoding haptic data, and can achieve the same technical effects. To avoid repetition, details are not described here.

The processor is a processor in the terminal described in the above embodiment. The readable storage medium includes a computer-readable storage medium, such as a computer read-only memory (ROM), a random access memory (RAM), a magnetic disk, or an optical disk. In some examples, the readable storage medium may be a non-transitory readable storage medium.

An embodiment of this application further provides a chip. The chip includes a processor and a communication interface, and the communication interface is coupled to the processor. The processor is configured to execute a program or an instruction to implement each process of the embodiment of the above method for encoding haptic data or implement each process of the embodiment of the above method for decoding haptic data, and can achieve the same technical effects. To avoid repetition, details are not described here.

It is to be understood that the chip mentioned in this embodiment of this application may also be referred to as a system level chip, a system chip, a chip system, a system on chip, or the like.

An embodiment of this application further provides a computer program/program product. The computer program/program product is stored in a storage medium. The computer program/program product is executed by at least one processor to implement each process of the embodiment of the above method for encoding haptic data or the method for decoding haptic data, and can achieve the same technical effects. To avoid repetition, details are not described here.

An embodiment of this application further provides an encoding and decoding system, including: an encoding-side device and a decoding-side device. The encoding-side device may be configured to execute the steps of the method for encoding haptic data as mentioned above, and the decoding-side device may be configured to execute the steps of the method for decoding haptic data as mentioned above.

It is to be noted that the terms "include", "comprise", or any other variants thereof herein are intended to encompass a non-exclusive inclusion, so that a process, a method, an object, or an apparatus including a series of elements not only includes those elements, but also includes other elements that are not explicitly listed, or further includes elements that are inherent to such a process, a method, an object, or an apparatus. Without more limitations, an element defined by a sentence "including one ..." does not exclude existence of other same elements in the process, the method, the object, or the apparatus that includes the element. In addition, it is to be noted that a scope of the method and the apparatus in the implementations of this application is not limited to performing functions according to a sequence that is shown or discussed, but may further include performing functions in a substantially simultaneous manner or in a reversed sequence according to the functions involved. For example, the described method may be performed in a different order than a described order, and various steps may be added, omitted, or combined. In addition, features described with reference to some examples may be combined in other examples.

Through the description of the above implementations, those skilled in the art can clearly understand that the methods according to the above embodiments may be implemented by a computer software product and a necessary general hardware platform, and certainly, may be implemented by hardware. The computer software product is stored in a storage medium (such as an ROM, an RAM, a magnetic disk, or an optical disk) and includes several instructions for instructing a terminal or a network side device to perform the methods described in the embodiments of this application.

The embodiments of this application are described above with reference to the accompanying drawings. However, this application is not limited to the specific implementations described above, and the specific implementations described above are only exemplary and not limitative. Those of ordinary skill in the art can make various forms of implementations under the teaching of this application without departing from the spirit of this application and the protection scope of the claims, and these implementations shall all fall within the protection scope of this application.

**Claims**

1. A method for encoding haptic data, comprising:

   obtaining a position of each of a plurality of keyframes of an effect in haptic data, wherein the plurality of keyframes comprise a first target keyframe and a second target keyframe, and the second target keyframe is a keyframe located before the first target keyframe;
   determining encoding position information of the first target keyframe, wherein the encoding position information of the first target keyframe is determined according to a difference between a position of the first target keyframe and a position of the second target keyframe; and
   encoding the encoding position information of the first target keyframe to obtain a first encoding result, wherein an encoding result of the haptic data comprises the first encoding result.

2. The method according to claim 1, wherein the second target keyframe is a keyframe located before the first target keyframe and closest to the first target keyframe.

3. The method according to claim 1, wherein after the determining encoding position information of the first target keyframe, the method further comprises:

   determining a first bit number, wherein the first bit number is determined based on encoding position information corresponding to each of the plurality of keyframes; and
   the encoding the encoding position information of the first target keyframe to obtain a first encoding result comprises:
   encoding the encoding position information of the first target keyframe by using the first bit number as an encoding bit number to obtain a first encoding result.

4. The method according to claim 3, wherein the determining a first bit number comprises:

   determining a maximum value of the encoding position information corresponding to the plurality of keyframes; and
   determining an encoding bit number required by the maximum value as the first bit number.

5. The method according to claim 3 or 4, wherein the encoding result of the haptic data further comprises the first bit number.

6. The method according to any one of claims 1 to 5, wherein the first target keyframe is a keyframe in the plurality of keyframes other than a third target keyframe, and the third target keyframe is a first keyframe of the effect; and
   the method further comprises:

   encoding encoding position information of the third target keyframe to obtain a second encoding result, wherein the encoding result of the haptic data further comprises the second encoding result.

7. The method according to claim 6, wherein the encoding encoding position information of the third target keyframe to obtain a second encoding result comprises:

   determining the second encoding result as a preset value in a case that a position of the third target keyframe is the same as an effect position of the effect; or
   encoding the encoding position information of the third target keyframe based on a preset encoding bit number in a case that the position of the third target keyframe is different from the effect position of the effect to obtain the second encoding result.

8. The method according to claim 3, wherein the first target keyframe is a keyframe in the plurality of keyframes other than a third target keyframe, the third target keyframe is a first keyframe of the effect, and the first bit number is determined based on encoding position information corresponding to a keyframe in the plurality of keyframes other than the third target keyframe; and
   the encoding the encoding position information of the first target keyframe by using the first bit number as an encoding bit number to obtain a first encoding result comprises:

determining a second bit number in a case that a position of the third target keyframe is different from an effect position of the effect, wherein the second bit number represents an encoding bit number required for encoding the encoding position information of the third target keyframe;

updating the first bit number to the second bit number in a case that the second bit number is greater than the first bit number; and

encoding the encoding position information of the first target keyframe by using the updated first bit number as an encoding bit number to obtain a first encoding result.

9.  The method according to claim 8, wherein the method further comprises:

encoding the encoding position information of the third target keyframe by using the updated first bit number as an encoding bit number to obtain a second encoding result,

wherein the encoding result of the haptic data further comprises the second encoding result.

10. The method according to any one of claims 1 to 9, wherein in a case that different keyframes of the effect are respectively located in a first data packet and a second data packet and a keyframe before a fourth target keyframe is located in the first data packet, encoding position information of the fourth target keyframe is determined according to a difference between a position of the fourth target keyframe and a start time position of the second data packet, or the encoding position information of the fourth target keyframe is determined according to a difference between the position of the fourth target keyframe and the effect position of the effect,

wherein the fourth target keyframe is a first keyframe in the second data packet, and the first target keyframe is a keyframe in the plurality of keyframes other than the fourth target keyframe.

11. The method according to any one of claims 1 to 10, wherein the obtaining a position of each of a plurality of keyframes of an effect in haptic data comprises:

obtaining a keyframe list of the effect in the haptic data, wherein the keyframe list comprises positions of the plurality of keyframes, and the positions of the plurality of keyframes are arranged in chronological order.

12. A method for decoding haptic data, comprising:

decoding a first encoding result in an encoding result of the haptic data to obtain encoding position information of a first target keyframe, wherein the encoding position information corresponding to the first target keyframe is determined according to a difference between a position of the first target keyframe and a position of a second target keyframe, the first target keyframe and the second target keyframe are keyframes in a plurality of keyframes of an effect in the haptic data, and the second target keyframe is a keyframe located before the first target keyframe; and

determining the position of the first target keyframe based on the encoding position information of the first target keyframe.

13. The method according to claim 12, wherein the second target keyframe is a keyframe located before the first target keyframe and closest to the first target keyframe.

14. The method according to claim 12 or 13, wherein the decoding a first encoding result in an encoding result of the haptic data to obtain encoding position information of a first target keyframe comprises:

decoding the first encoding result in the encoding result of the haptic data based on a first bit number to obtain the encoding position information of the first target keyframe,

wherein the first bit number is an encoding bit number for encoding the encoding position information of the first target keyframe.

15. The method according to claim 14, wherein the encoding result of the haptic data further comprises the first bit number, and the first bit number is determined based on encoding position information corresponding to each of the plurality of keyframes.

16. The method according to claim 14 or 15, wherein the first bit number is an encoding bit number required by a maximum value of the encoding position information corresponding to the plurality of keyframes.

17. The method according to any one of claims 12 to 16, wherein the encoding result of the haptic data further comprises a second encoding result, the first target keyframe is a keyframe in the plurality of keyframes other than a third target keyframe, the third target keyframe is a first keyframe of the effect, and the method further comprises:
determining a position of the third target keyframe based on the second encoding result.

18. The method according to claim 17, wherein the determining a position of the third target keyframe based on the second encoding result comprises:

determining that the position of the third target keyframe is the same as an effect position of the effect in a case that the second encoding result is a preset value; or
decoding the second encoding result based on a preset encoding bit number in a case that the second encoding result is not the preset value to obtain encoding position information of the third target keyframe; and determining the position of the third target keyframe based on the encoding position information of the third target keyframe.

19. An apparatus for encoding haptic data, comprising:

an obtaining module, configured to obtain a position of each of a plurality of keyframes of an effect in haptic data, wherein the plurality of keyframes comprise a first target keyframe and a second target keyframe, and the second target keyframe is a keyframe located before the first target keyframe;
a first determining module, configured to determine encoding position information of the first target keyframe, wherein the encoding position information of the first target keyframe is determined according to a difference between a position of the first target keyframe and a position of the second target keyframe; and
a first encoding module, configured to encode the encoding position information of the first target keyframe to obtain a first encoding result,
wherein an encoding result of the haptic data comprises the first encoding result.

20. An apparatus for decoding haptic data, comprising:

a decoding module, configured to decode a first encoding result in an encoding result of the haptic data to obtain encoding position information of a first target keyframe, wherein the encoding position information corresponding to the first target keyframe is determined according to a difference between a position of the first target keyframe and a position of a second target keyframe, the first target keyframe and the second target keyframe are keyframes in a plurality of keyframes of an effect in the haptic data, and the second target keyframe is a keyframe located before the first target keyframe; and
a first determining module, configured to determine the position of the first target keyframe based on the encoding position information of the first target keyframe.

21. A terminal, comprising a processor, a memory, and a program or instruction stored on the memory and executable on the processor, wherein the program or instruction, when executed by the processor, implements steps of the method for encoding haptic data according to any one of claims 1 to 11; or the program or instruction, when executed by the processor, implements steps of the method for decoding haptic data according to any one of claims 12 to 18.

22. A readable storage medium, storing a program or an instruction, wherein the program or instruction, when executed by a processor, implements steps of the method for encoding haptic data according to any one of claims 1 to 11; or the program or instruction, when executed by a processor, implements steps of the method for decoding haptic data according to any one of claims 12 to 18.

FIG. 1

FIG. 2

Start

Obtain a position of each of a plurality of keyframes of an effect in haptic data — 101

Determine encoding position information of the first target keyframe — 102

Encode the encoding position information of the first target keyframe to obtain a first encoding result — 103

End

FIG. 3

$t_{e1}$   $t_{e2}$   $t_{e3}$   $t_{e4}$

Effect (effect) 1   Effect 2   Effect 3   Effect 4

$T_0$   Packet (packet) 1   $T_1$   $T_2$   Packet 2   $T_3$   Packet 3

FIG. 4

Start

Decode a first encoding result in an encoding result of haptic data to obtain encoding position information of a first target keyframe — 201

Determine a position of the first target keyframe based on the encoding position information of the first target keyframe — 202

End

## FIG. 5

— 300

Apparatus for encoding haptic data

Obtaining module — 301

First determining module — 302

First encoding module — 303

## FIG. 6

— 400

Apparatus for decoding haptic data

Decoding module — 401

First determining module — 402

## FIG. 7

500

Communication device

501 Processor ⟷ Memory 502

FIG. 8

600

601 Radio frequency unit

Network module 602

610

Memory

609 Application program

Operating system

608 Interface unit

607 User input unit

6071 Touch panel

6072 Other input device

Processor

Audio output unit 603

604

Input unit

Graphics processing unit (GPU) 6041

Microphone 6042

606

Display unit 6061

Display panel

Sensor 605

FIG. 9

## INTERNATIONAL SEARCH REPORT

| International application No. |
| --- |
| **PCT/CN2024/082836** |

### A. CLASSIFICATION OF SUBJECT MATTER

G06F3/01(2006.01)i

According to International Patent Classification (IPC) or to both national classification and IPC

### B. FIELDS SEARCHED

Minimum documentation searched (classification system followed by classification symbols)

IPC:G06F

Documentation searched other than minimum documentation to the extent that such documents are included in the fields searched

Electronic data base consulted during the international search (name of data base and, where practicable, search terms used)

CJFD, CNTXT, DWPI, ENTXT, ENTXTC, VEN, WPABS, WPABSC: 编码, 编码位置, 触觉, 触觉编码, 触觉数据, 触觉信号, 触觉信息, 关键帧, 解码, 位置, 位置信息, 比特位数, 比特数coding, keyframe, location, position, tactile, touch, decod+, cod+, bit

### C. DOCUMENTS CONSIDERED TO BE RELEVANT

| Category* | Citation of document, with indication, where appropriate, of the relevant passages | Relevant to claim No. |
| --- | --- | --- |
| X | CN 108803869 A (IMMERSION CORP.) 13 November 2018 (2018-11-13) description, paragraphs [0029]-[0063], and figures 2-5 | 1-2, 11, 19, 21-22 |
| A | CN 103869969 A (IMMERSION CORP.) 18 June 2014 (2014-06-18) entire description | 1-22 |
| A | CN 107710107 A (THOMSON LICENSING L.L.C.) 16 February 2018 (2018-02-16) entire description | 1-22 |
| A | CN 108255295 A (IMMERSION CORP.) 06 July 2018 (2018-07-06) entire description | 1-22 |

☐ Further documents are listed in the continuation of Box C.    ☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **30 May 2024** | **07 June 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| International application No. |
|---|
| **PCT/CN2024/082836** |

| Patent document cited in search report | | | Publication date (day/month/year) | Patent family member(s) | | | Publication date (day/month/year) |
|---|---|---|---|---|---|---|---|
| CN | 108803869 | A | 13 November 2018 | EP | 2728443 | A2 | 07 May 2014 |
| | | | | EP | 2728443 | A3 | 08 June 2016 |
| | | | | US | 2016320845 | A1 | 03 November 2016 |
| | | | | US | 9958944 | B2 | 01 May 2018 |
| | | | | EP | 3495924 | A1 | 12 June 2019 |
| | | | | EP | 3495924 | B1 | 07 June 2023 |
| | | | | US | 2014125467 | A1 | 08 May 2014 |
| | | | | US | 8947216 | B2 | 03 February 2015 |
| | | | | JP | 2014093091 | A | 19 May 2014 |
| | | | | JP | 6359820 | B2 | 18 July 2018 |
| | | | | JP | 2018163691 | A | 18 October 2018 |
| | | | | JP | 6734325 | B2 | 05 August 2020 |
| | | | | US | 2015102918 | A1 | 16 April 2015 |
| | | | | US | 9396630 | B2 | 19 July 2016 |
| | | | | KR | 20140057160 | A | 12 May 2014 |
| | | | | KR | 102161541 | B1 | 05 October 2020 |
| | | | | US | 2018267610 | A1 | 20 September 2018 |
| | | | | US | 10248212 | B2 | 02 April 2019 |
| CN | 103869969 | A | 18 June 2014 | US | 2014160034 | A1 | 12 June 2014 |
| | | | | US | 9898084 | B2 | 20 February 2018 |
| | | | | JP | 2014115999 | A | 26 June 2014 |
| | | | | JP | 6258023 | B2 | 10 January 2018 |
| | | | | JP | 2018037112 | A | 08 March 2018 |
| | | | | JP | 6479148 | B2 | 06 March 2019 |
| | | | | KR | 20140074833 | A | 18 June 2014 |
| | | | | KR | 102207669 | B1 | 25 January 2021 |
| | | | | US | 2019272039 | A1 | 05 September 2019 |
| | | | | EP | 2741174 | A2 | 11 June 2014 |
| | | | | EP | 2741174 | A3 | 18 May 2016 |
| | | | | US | 2018046252 | A1 | 15 February 2018 |
| | | | | US | 10359851 | B2 | 23 July 2019 |
| CN | 107710107 | A | 16 February 2018 | WO | 2017001293 | A1 | 05 January 2017 |
| | | | | US | 2019156639 | A1 | 23 May 2019 |
| | | | | US | 10692336 | B2 | 23 June 2020 |
| | | | | JP | 2018526722 | A | 13 September 2018 |
| | | | | JP | 6771497 | B2 | 21 October 2020 |
| | | | | EP | 3112987 | A1 | 04 January 2017 |
| | | | | KR | 20180021722 | A | 05 March 2018 |
| | | | | EP | 3314370 | A1 | 02 May 2018 |
| CN | 108255295 | A | 06 July 2018 | US | 2018182436 | A1 | 28 June 2018 |
| | | | | US | 10147460 | B2 | 04 December 2018 |
| | | | | US | 2019074037 | A1 | 07 March 2019 |
| | | | | US | 10720189 | B2 | 21 July 2020 |
| | | | | EP | 3343328 | A1 | 04 July 2018 |
| | | | | KR | 20210087921 | A | 13 July 2021 |
| | | | | EP | 3343329 | A1 | 04 July 2018 |
| | | | | EP | 3343329 | B1 | 26 February 2020 |
| | | | | JP | 2018109984 | A | 12 July 2018 |
| | | | | JP | 6893868 | B2 | 23 June 2021 |
| | | | | US | 2020349982 | A1 | 05 November 2020 |

Form PCT/ISA/210 (patent family annex) (July 2022)

## INTERNATIONAL SEARCH REPORT
### Information on patent family members

International application No.

**PCT/CN2024/082836**

| Patent document cited in search report | Publication date (day/month/year) | Patent family member(s) | | Publication date (day/month/year) |
|---|---|---|---|---|
| | | KR 20180077091 | A | 06 July 2018 |
| | | KR 102276173 | B1 | 12 July 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310312430